# EUROPÄISCHE PATENTSCHRIFT

(11) **EP 1 216 353 B1**
(45) Veröffentlichungstag und Bekanntmachung des Hinweises auf die Patenterteilung: **23.11.2005**
(21) Anmeldenummer: 00971262.1
(22) Anmeldetag: 27.09.2000
(51) Int. Cl.: F02D 41/20

(54) **VORBEHANDLUNGSVERFAHREN FÜR EINEN ELEKTRO-MECHANISCHEN WANDLER**
METHOD FOR INITIALISING AN ELECTRO-MECHANICAL CONVERTER
PROCEDE DE PRETRAITEMENT D'UN CONVERTISSEUR ELECTRO-MECANIQUE

(30) Priorität: 29.09.1999 DE 19946718
(43) Veröffentlichungstag der Anmeldung: 26.06.2002
(73) Patentinhaber: SIEMENS AKTIENGESELLSCHAFT, 80333 München (DE)
(72) Erfinder: ZUMSTRULL, Claus, 93128 Regenstauf (DE)
(86) Internationale Anmeldenummer: PCT/DE2000/003360
(87) Internationale Veröffentlichungsnummer: WO 2001/023736

(56) Entgegenhaltungen:
- EP-A- 0 324 450
- GB-A- 2 219 145
- US-A- 4 705 003
- US-A- 4 899 714
- PATENT ABSTRACTS OF JAPAN vol. 012, no. 315 (M-735), 26. August 1988 (1988-08-26) & JP 63 088246 A (NIPPON DENSO CO LTD;OTHERS: 01), 19. April 1988 (1988-04-19)
- PATENT ABSTRACTS OF JAPAN vol. 018, no. 641 (E-1639), 6. Dezember 1994 (1994-12-06) & JP 06 245552 A (SUMITOMO METAL IND LTD), 2. September 1994 (1994-09-02)

## Beschreibung

Die Erfindung betrifft ein Vorbehandlungsverfahren für einen elektromechanischen Wandler, zur Vorpolung eines piezoelektrischen Stellgliedes für eine Einspritzanlage einer Brennkraftmaschine gemäß dem Oberbegriff des Anspruchs 1, gemäß US 4, 853, 714.

In herkömmlichen Common-Rail-Einspritzanlagen für Brennkraftmaschinen werden elektromechanische Wandler in Form von piezoelektrischen Stellgliedern verwendet, um in den Injektoren der Einspritzanlage die Einspritzung von Kraftstoff in die Brennräume der Brennkraftmaschine zu steuern. Das piezoelektrische Substrat derartiger piezoelektrischer Stellglieder weist üblicherweise eine Vielzahl räumlich verteilt angeordneter Domänen auf, die teilweise unterschiedlich ausgerichtet sind. Vor dem eigentlichen Betrieb werden die piezoelektrischen Stellglieder deshalb gepolt, um die einzelnen Domänen innerhalb des piezoelektrischen Substrates einheitlich auszurichten. Hierzu wird das piezoelektrische Substrat einem elektrischen Signal ausgesetzt. Nachteilig daran ist, daß im anschließenden normalen Betrieb der piezoelektrischen Stellglieder ein dauerndes Nachpolen des piezoelektrischen Substrates stattfindet, wodurch sich der Betriebspunkt der piezoelektrischen Stellglieder verschiebt, was zu einem veränderten Stellverhalten führt.

Der Erfindung liegt somit die Aufgabe zugrunde, ein Vorbehandlungsverfahren für ein piezoelektrisches Stellglied zu schaffen, das eine dauerhafte Einstellung eines vorgegebenen Betriebspunktes ermöglicht, ohne daß sich der Betriebspunkt anschließend im normalen Betrieb des piezoelektrischen Stellgliedes verschiebt.

Die Aufgabe wird - ausgehend von dem eingangs beschriebenen bekannten Vorbehandlungsverfahren - gemäß dem Oberbegriff des Anspruchs 1, durch die kennzeichnenden Merkmale des Anspruchs 1 gelöst.

Es ist vorgesehen, im Rahmen des dem eigentlichen Betrieb vorgeschalteten Behandlungsvorganges die elektrischen, mechanischen, thermischen und/oder magnetischen Randbedingungen vorzugeben, die während des eigentlichen Betriebs auftreten.

Der elektromechanische Wandler wird während des Behandlungsvorganges mit einem elektrischen Behandlungssignal angesteuert, das im wesentlichen dem elektrischen Ansteuersignal während des normalen Betriebes entspricht, um eine Verschiebung des voreingestellten Betriebspunktes während des normalen Betriebes zu verhindern. Hierzu besteht das Vorbehandlungssignal vorzugsweise im wesentlichen aus einer Pulsfolge, wobei die Pulsfrequenz vorzugsweise im wesentlichen gleich der Ansteuerfrequenz im normalen Betrieb ist. Übliche Werte für die Pulsfrequenz liegen somit zwischen 10 und 120 Hz, wobei eine Ansteuerfrequenz von 55 Hz bevorzugt wird. Als Pulsdauer für das Vorbehandlungssignal eignen sich vorzugsweise Werte im Bereich zwischen 0,1 ms und 2 ms, wobei sich ein Wert von 1,4 ms für die Pulsdauer des Vorbehandlungssignals als besonders vorteilhaft erwiesen hat.

Vorzugsweise wird der Wandler bei der Ansteuerung mit dem Behandlungssignal zusätzlich mechanisch belastet, um den normalen Betriebszustand während der Vorbehandlung zu simulieren. Hierzu wird der Wandler vorzugsweise mit einer Kraft von 400 N bis 1.000 N auf Druck belastet, wobei sich eine Vorspannkraft von 850 N als besonders vorteilhaft erwiesen hat.

Gemäß einer weiterbildenden Variante der Erfindung wird zusätzlich die Betriebstemperatur simuliert, indem der Wandler vor der eigentlichen Vorbehandlung auf die normale Betriebstemperatur gebracht wird, die üblicherweise zwischen +50°C und +150°C liegt, wobei sich als Temperatur für den Vorbehandlungsvorgang ein Wert von +80°C als besonders vorteilhaft erwiesen hat.

Nach einer weiterbildenden Variante der Erfindung wird während des Vorbehandlungsverfahrens das Ansprechverhalten des Wandlers gemessen, um eine Information über den Vorbehandlungszustand des Wandlers zu erhalten. Die so gewonnene Information kann beispielsweise genutzt werden, um die Vorbehandlungsparameter anzupassen oder den Vorbehandlungsvorgang nach Erreichen des gewünschten Zustandes zu beenden. Hierzu wird die elektrische Spannung, der elektrische Strom und/oder die durch den Wandler geflossene elektrische Ladung gemessen werden.

Andere vorteilhafte Weiterbildungen der Erfindung sind in den Unteransprüchen gekennzeichnet bzw. werden nachstehend zusammen mit der Beschreibung des bevorzugten Ausführungsbeispiels der Erfindung anhand der Figuren näher dargestellt.

In der Zeichnung ist der erfindungsgemäße Vorbehandlungsvorgang in Form eines Flußdiagramms dargestellt.

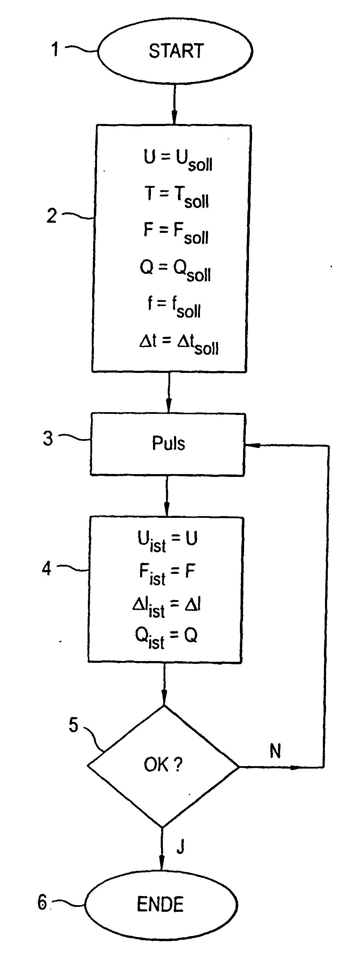

Bei dem in Figur 1 dargestellten erfindungsgemäßen Vorbehandlungsverfahrens werden nach einem Startschritt 1 zunächst und im weiteren Schritt 2 die Vorbehandlungsparameter für den eigentlichen Vorbehandlungsvorgang festgelegt. So erfolgt die Vorbehandlung in Form einer Polung des piezoelektrischen Stellgliedes mit einer elektrischen Pulsfolge mit einer Frequenz von f=55 Hz, einer Ansteuerzeit von Δt=1,0 ms, einer Ladeenergie W=80 mJ, einer Ladezeit von t_{L}=100 µs und einer Temperatur von T=+80°C, wobei das elektrische Stellglied mit einer Vorspannkraft von F=850 N auf Druck belastet wird. Nach der Vorgabe dieser Vorbehandlungsparameter wird dann in einem nächsten Schritt 3 ein elektrischer Impuls auf das piezoelektrische Stellglied gegeben. Anschließend wird dann in einem weiteren Meßschritt 4 das Ansprechverhalten des piezoelektrischen Stellgliedes auf den vorangegangenen Impuls ermittelt, in dem die Spannung U, die Kraft F, der Hub Δl sowie die während des Impulses über das piezoelektrische Stellglied geflossene Ladung Q gemessen werden.

Daraufhin wird in einem Auswertungsschritt 5 ermittelt, ob der Vorbehandlungsvorgang beendet werden kann. Hierzu werden die in dem Meßschritt 4 ermittelten Meßwerte des piezoelektrischen Stellgliedes unter Berücksichtigung von zugelassenen Toleranzbandbreiten mit vorgegebenen Sollwerten verglichen. Falls sich die Meßwerte innerhalb der Toleranzbandbreiten bewegen, so wird das Vorbehandlungsverfahren in einem Abschlußschritt 6 beendet. Liegen dagegen einzelne oder mehrere Meßparameter außerhalb der Toleranzbandbreiten, so wird zu Schritt 3 zurückgegangen und ein weiterer Impuls auf das piezoelektrische Stellglied gegeben, bis die in Schritt 4 gemessenen Werte innerhalb der Toleranzbandbreiten liegen.

## Patentansprüche

1. Vorbehandlungsverfahren für einen elektro-mechanischen Wandler in einem piezoelektrischen Stellglied für eine Einspritzanlage einer Brennkraftmaschine zur Polung des Stellglieds, bei dem der Wandler vor dem eigentlichen Betrieb mit einem elektrischen Vorbehandlungssignal angesteuert wird, um einen vorgegebenen Betriebspunkt entsprechend dem Vorbehandlungssignal einzustellen,
wobei das Vorbehandlungssignal eine Pulsfolge ist, die im wesentlichen dem elektrischen Ansteuersignal während des normalen Wandlerbetriebs entspricht, um eine Verschiebung des voreingestellten Betriebspunkts während des normalen Wandlerbetriebs zu verhindern,
**dadurch gekennzeichnet,**
- **dass** während der Ansteuerung mit dem Vorbehandlungssignal das elektrische Ansprechverhalten des Wandlers gemessen wird, um eine Information über den Vorbehandlungszustand des Wandlers zu erhalten, und
- **dass** während der Ansteuerung mit dem Vorbehandlungssignal die elektrische Spannung und/oder der elektrische Strom und/oder die durch den Wandler geflossene elektrische Ladung gemessen wird, um eine Information über den Vorbehandlungszustand zu erhalten.

2. Verfahren nach Anspruch 1,
**dadurch gekennzeichnet,**
**dass** der Wandler bei der Ansteuerung mit dem Vorbehandlungssignal mechanisch belastet wird, wobei die mechanische Belastung im wesentlichen der mechanischen Belastung während des normalen Betriebs entspricht.

3. Verfahren nach Anspruch 2,
**dadurch gekennzeichnet,**
**dass** der Wandler bei der Ansteuerung mit dem Vorbehandlungssignal mit einer Kraft von 400 N bis 1000 N auf Druck belastet wird.

4. Verfahren nach einem der vorhergehenden Ansprüche,
**dadurch gekennzeichnet,**
**dass** der Wandler vor der Ansteuerung mit dem Vorbehandlungssignal auf eine Temperatur gebracht wird, die im wesentlichen der Betriebstemperatur entspricht.

5. Verfahren nach Anspruch 4,
**dadurch gekennzeichnet,**
**dass** der Wandler vor der Ansteuerung mit dem Vorbehandlungssignal auf eine Temperatur zwischen +50°C und +150°C gebracht wird.

6. Verfahren nach einem der vorhergehenden Ansprüche,
**dadurch gekennzeichnet,**
**dass** das Vorbehandlungssignal im Wesentlichen aus einer Pulsfolge besteht, wobei die Pulsfrequenz im Wesentlichen gleich der Ansteuerfrequenz im normalen Betrieb ist.

7. Verfahren nach einem der vorhergehenden Ansprüche,
**dadurch gekennzeichnet,**
**dass** die Pulsfrequenz des Vorbehandlungssignals zwischen 10 Hz und 120 Hz liegt.

8. Verfahren nach Anspruch 6 oder 7,
**dadurch gekennzeichnet,**
**dass** die Pulsdauer des Vorbehandlungssignals im Wesentlichen zwischen 0,1 ms und 2 ms liegt.

9. Verfahren nach einem der vorhegehenden Ansprüche,
**dadurch gekennzeichnet,**
**dass** das Ansprechverhalten des Wandlers mit vorgegebenen Referenzwerten verglichen und der Vorbehandlungsvorgang beim Erreichen eines oder mehrere der Referenzwerte abgebrochen wird.

## Claims

1. Preprocessing method for an electro-mechanical converter in a piezoelectric actuator for an injection system of an internal combustion engine for polarizing the actuator, in which the actuator is activated before its actual operation with an electrical preprocessing signal in order to set a predetermined operating point in accordance with the preprocessing signal,
with the preprocessing signal being a pulse sequence which essentially corresponds to the electrical activation signal during normal converter operation, to prevent the predetermined operating point shifting during the normal converter operation,
**characterized in that**,
- during the activation with the preprocessing signal the electrical activation behavior of the converter is measured to obtain information about the preprocessing state of the converter, and
- during the activation with the preprocessing signal the electrical voltage EW, the electrical current and/or the charge which has flowed through the converter is measured to obtain information about the preprocessing state.

2. Method in accordance with claim 1,
**characterized in that**,
a mechnical load is imposed on the converter on activation with the preprocessing signal, with the mechanical load essentially corresponding to the mechnaical load during normal operation.

3. Method in accordance with claim 2,
**characterized in that**,
a pressure of 400 N to 1000 N is imposed on the converter when it is activated with the preprocessing signal.

4. Method in accordance with one of the previous claims,
**characterized in that**,
before activation with the preprocessing signal the converter is set to a temperature which essentially corresponds to the operating temperature.

5. Method in accordance with claim 4,
**characterized in that**,
before activation with the preprocessing signal the converter is set to a temperature of between +50°C und +150°C.

6. Method in accordance with one of the previous claims,
**characterized in that**,
the preprocessing signal essentially consists of a pulse sequence, with the pulse frequency essentially being the same as the activation frequency in normal operation.

7. Method in accordance with one of the previous claims,
**characterized in that**,
the pulse frequency of the preprocessing signal lies between 10 Hz and 120 Hz.

8. Method in accordance with claim 6 or 7,
**characterized in that**,
the pulse duration of the preprocessing signal essentially lies between 0.1 ms and 2 ms.

9. Method in accordance with one of the previous claims
**characterized in that**,
the response behavior of the converter is compared to predetermined reference values und the preprocessing process aborted on reaching one or more of the reference values.

## Revendications

1. Procédé de traitement préalable pour un convertisseur électromécanique dans un organe de réglage piézo-électrique pour un dispositif d'injection d'un moteur à combustion interne, en vue du réglage de la polarité de l'organe piézo-électrique, procédé dans lequel le convertisseur est, avant le fonctionnement proprement dit, amorcé avec un signal électrique de traitement préalable pour régler un point de fonctionnement prédéfini en fonction du signal de traitement préalable,
le signal de traitement préalable étant un train d'impulsions qui correspond essentiellement au signal électrique d'amorçage pendant le fonctionnement normal du convertisseur pour empêcher, pendant le fonctionnement normal du convertisseur, un décalage du point de fonctionnement préréglé,
**caractérisé**
- **en ce que**, pendant l'amorçage avec le signal de traitement préalable, le comportement d'amorçage électrique du convertisseur est mesuré pour obtenir une information sur l'état du traitement préalable du convertisseur, et
- **en ce que**, pendant l'amorçage avec le signal de traitement préalable, la tension électrique et/ou le courant électrique et/ou la charge électrique traversant le convertisseur sont mesurés pour obtenir une information sur l'état du traitement préalable.

2. Procédé suivant la revendication 1,
**caractérisé en ce que**
le convertisseur lors de l'amorçage avec le signal de traitement préalable reçoit une charge mécanique, cette charge mécanique correspondant essentiellement à la charge mécanique pendant le fonctionnement normal.

3. Procédé suivant la revendication 2,
**caractérisé en ce que**
le convertisseur, lors de l'amorçage avec le signal de traitement préalable, est soumis à la charge d'une force de 400 N à 1000 N en pression.

4. Procédé suivant l'une des revendications précédentes,
**caractérisé en ce que**
le convertisseur, avant l'amorçage avec le signal de traitement préalable, est porté à une température qui correspond essentiellement à la température de fonctionnement.

5. Procédé suivant la revendication 4,
**caractérisé en ce que**
le convertisseur, avant le l'amorçage avec le signal de traitement préalable, est porté à une température comprise entre +50°C et +150°C.

6. Procédé suivant l'une des revendications précédentes,
**caractérisé en ce que**
le signal de traitement préalable est essentiellement constitué d'un train d'impulsions, la fréquence des impulsions étant essentiellement égale à la fréquence des impulsions en fonctionnement normal.

7. Procédé suivant l'une des revendications précédentes,
**caractérisé en ce que** la fréquence des impulsions du signal de traitement préalable est comprise entre 10 Hz et 120 Hz.

8. Procédé suivant la revendication 6 ou 7,
**caractérisé en ce que**
la durée de pulsation du signal de traitement préalable est essentiellement comprise entre 0,1 ms et 2 ms.

9. Procédé suivant l'une des revendications précédentes,
**caractérisé en ce que**
le comportement d'amorçage du convertisseur est comparé avec des valeurs de référence prédéfinies et l'opération de traitement préalable est interrompue lorsqu'une ou plusieurs valeurs de référence est ou sont obtenues.
